# EUROPEAN PATENT APPLICATION

(11) **EP 4 167 281 A1**
(43) Date of publication of application: **19.04.2023**
(21) Application number: 21872811.1
(22) Date of filing: 14.09.2021
(51) Int. Cl.: H01L 25/075, H01L 27/12, H01L 25/16, H01L 21/52

(54) **DISPLAY MODULE HAVING SIDE WIRING AND METHOD FOR MANUFACTURING SAME**

(30) Priority: 22.09.2020 KR 20200122537
(71) Applicant: Samsung Electronics Co., Ltd., Gyeonggi-do 16677 (KR); Enjet Co., Ltd., Gyeonggi-do 16643 (KR)
(72) Inventor: BYUN, Doyoung, Suwon-si Gyeonggi-do 16643 (KR); JANG, Yonghee, Suwon-si Gyeonggi-do 16643 (KR); KUK, Keon, Suwon-si Gyeonggi-do 16677 (KR); KIM, Seongyong, Suwon-si Gyeonggi-do 16677 (KR); JUNG, Jinwoo, Suwon-si Gyeonggi-do 16677 (KR); HONG, Soonmin, Suwon-si Gyeonggi-do 16677 (KR); LEE, Tackmo, Suwon-si Gyeonggi-do 16677 (KR); HEO, Gyun, Suwon-si Gyeonggi-do 16677 (KR)
(74) Representative: Appleyard Lees IP LLP
(86) International application number: PCT/KR2021/012469
(87) International publication number: WO 2022/065782

(57) **Abstract**

Disclosed is a display module. The disclosed display module comprises: a thin film transistor (TFT) substrate that includes a glass substrate and a TFT layer on the front surface of the glass substrate, wherein the TFT layer includes a TFT circuit; a plurality of light emitting diodes mounted in the TFT layer; a plurality of first connection pads formed at distances on the front surface of the glass substrate and electrically connected to the TFT circuit; a plurality of second connection pads formed at distances on the rear surface of the glass substrate and electrically connected to a circuit for supplying power and connecting to a control board; and a plurality of side wires electrically connecting the first connection pads to the corresponding second connection pads, respectively, wherein each of the side wires is wider than the corresponding first connection pad and the corresponding second connection pad.

## Description

### [TECHNICAL FIELD]

The present disclosure relates to a display module having a side wiring and a method for manufacturing the same, and more particularly, to a display module having a side wiring positioned on an edge area of a glass substrate, and a method for manufacturing the same.

### CROSS-REFERENCE TO RELATED APPLICATIONS

This application is based on and claims priority under 35 U.S.C. §119 to Korean Patent Application No. 10-2020-0122537, filed on September 22, 2020, in the Korean Intellectual Property Office, the disclosure of which is incorporated by reference herein in its entirety.

### [BACKGROUND ART]

A light-emitting display device may display an image without a color filter or a backlight, and use an inorganic light emitting diode (LED) light-emitting device emitting light by itself.

The display module may express various colors while being operated in units of pixels or sub-pixels including the inorganic LED light-emitting devices, and an operation of each pixel or sub-pixel may be controlled by a thin film transistor (TFT). The plurality of TFTs may be arranged on a flexible substrate, a glass substrate, or a plastic substrate, which is referred to as a TFT substrate.

The TFT substrate may be applied not only to a small device such as a flexible device or a wearable device (e.g., wearable watch) but also to a large television (TV) of several tens of inches, and utilized as a substrate for driving a display. To be driven, the TFT substrate may be connected to an external circuit (IC) or driver IC which may apply current to the TFT substrate. In general, the TFT substrate and each circuit may be connected to each other through chip on glass (COG) bonding or film on glass (FOG) bonding. For this connection, the TFT substrate may need to secure an area having a certain area at its edge, that is, a bezel area.

In recent years, research and development on bezel-less technology for minimizing the bezel area is in progress to maximize an active area (or an area where the image is displayed on a display panel) of the TFT substrate. As a part of this progress, disclosed is technology for positioning a plurality of side wirings each having a fine line width on an edge of the glass substrate.

### [DISCLOSURE]

### [TECHNICAL PROBLEM]

The present disclosure provides a display module which may maximizes a line width of a side wiring to provide stable power supply to a thin film transistor (TFT) circuit, efficient transmission of a control signal, and a minimized disconnection rate, and a method for manufacturing the same.

### [TECHNICAL SOLUTION]

According to an embodiment of the present disclosure, a display module includes: a thin film transistor (TFT) substrate including a glass substrate and a TFT layer provided on a front surface of the glass substrate, the TFT layer including a TFT circuit; a plurality of light emitting diodes provided on the TFT layer; a plurality of first connection pads provided at a distance from each other on the front surface of the glass substrate and electrically connected to the TFT circuit; a plurality of second connection pads provided at a distance from each other on a rear surface of the glass substrate and electrically connected to a circuit for supplying power and connected to a control board; and a plurality of side wirings electrically connecting each of the plurality of first connection pads to respective connection pads of the plurality of second connection pads, wherein each side wiring of the plurality of side wirings has a width greater than widths of a respectively connected first connection pad and second connection pad.

A distance between adjacent side wirings may be less than a distance between adjacent connection pads of the plurality of first connection pads or is less than a distance between adjacent connection pads of the plurality of second connection pads.

Each side wiring of the plurality of side wirings may have a first end covering at least a portion of one first connection pad and a second end covering at least a portion of one second connection pad.

According to another embodiment of the present disclosure, a method for manufacturing a display module includes: forming a thin film transistor (TFT) layer on a front surface of a glass substrate; arranging a plurality of first connection pads on a portion of the front surface of the glass substrate, adjacent to a side surface of the glass substrate, and arranging a plurality of second connection pads on a portion of a rear surface of the glass substrate, adjacent to the side surface of the glass substrate; forming a plurality of side wirings respectively connecting the plurality of first connection pads to the plurality of second connection pads; and transferring a plurality of light emitting diodes to the TFT layer, wherein each side wiring of the plurality of side wirings has a width greater than widths of a respectively connected first connection pad and second connection pad.

The forming of the plurality of side wirings may include: forming a masking layer such that the masking layer covers the front surface and the rear surface of the glass substrate and exposes the plurality of first connection pads and the plurality of second connection pads; forming a masking pattern from between adjacent connection pads of the plurality of first connection pads through the side surface of the glass substrate to between adjacent connection pads of the plurality of second connection pads; forming a metal thin film layer connecting each of the plurality of first connection pads to respective connection pads of the plurality of second connection pads; and removing the masking pattern and the masking layer from the glass substrate.

The masking pattern may be formed by electrohydrodynamic (EHD) jet printing.

The forming of the masking pattern may include: clamping the glass substrate by a jig such that the side surface of the glass substrate faces upward; and continuously forming the masking pattern on the front surface, the side surface and the rear surface of the glass substrate by discharging a material for the masking pattern while a nozzle from which the material for the masking pattern is discharged is moved in a straight line and in a horizontal direction.

The masking pattern may include a plurality of straight lines parallel to each other, and wherein each straight line of the plurality of straight lines has a width less than a distance between adjacent connection pads of the plurality of first connection pads and less than a distance between adjacent connection pads of the plurality of second connection pads.

In the clamping of the glass substrate by the jig, the glass substrate may be disposed in a direction perpendicular to a movement direction of the nozzle.

The forming of the masking pattern further may include increasing a thickness of each straight line of the plurality of straight lines by stacking material used for the masking pattern on the masking pattern while the nozzle is reciprocally moved.

In the forming of the masking pattern, two or more glass substrates may be clamped by the jig, and the glass substrates adjacent to each other are disposed at a distance from each other by a spacer.

The masking pattern may be formed on edge areas of the two or more glass substrates by the nozzle discharging a liquid material while being moved above the two or more glass substrates.

The material for the masking pattern may have a viscosity of 3,000 to 100,000 cPs.

The metal thin film layer may be formed by a deposition process.

The forming of the plurality of side wirings may include: forming a masking layer such that the masking layer covers the front surface and the rear surface of the glass substrate and exposes the plurality of first connection pads and the plurality of second connection pads; forming a straight-line masking pattern from between adjacent connection pads of the plurality of first connection pads through the side surface of the glass substrate to between adjacent connection pads of the plurality of second connection pads; forming a seed layer connecting each of the plurality of first connection pads to respective second connection pads; removing the masking pattern and the masking layer from the glass substrate; and stacking a metal thin film layer on the seed layer by electroless plating.

The forming of the plurality of side wirings may include: depositing a metal thin film layer covering portions of the side surface of the glass substrate and portions of the front surface and the rear surface of the glass substrate on which the plurality of first connection pads and the plurality of second connection pads are respectively arranged; forming an etching resist pattern on the metal thin film layer by electrohydrodynamic (EHD) jet printing to cover an area to be used for the plurality of side wirings; removing a portion of the metal thin film layer, not covered by the etching resist pattern, by wet etching; and removing the etching resist pattern.

The forming of the plurality of side wirings may include: forming a photoresist layer covering portions of the side surface of the glass substrate and portions of the front surface and the rear surface of the glass substrate on which the plurality of first connection pads and the plurality of second connection pads are respectively arranged; forming an exposure masking pattern on the photoresist layer by electrohydrodynamic (EHD) jet printing to cover an area to be used for the plurality of side wirings; removing the exposure masking pattern and the photoresist layer covered by the exposure masking pattern by exposure and development; depositing a metal thin film layer connecting each of the plurality of first connection pads to respective second connection pads of the plurality of second connection pads; and removing the photoresist layer.

### [DESCRIPTION OF DRAWINGS]

FIG. 1 is a plan view schematically showing a display module according to an embodiment of the present disclosure.
FIG. 2 is a cross-sectional view schematically showing the display module according to an embodiment of the present disclosure.
FIG. 3 is a partially enlarged view showing that a plurality of side wirings are arranged at a predetermined distance from each other in the display module according to an embodiment of the present disclosure.
FIG. 4 is a bottom view showing an example of a connection structure between a side wiring and a corresponding connection pad.
FIG. 5 is a schematic side cross-sectional view showing the connection structure between the side wiring and the connection pad shown in FIG. 3.
FIG. 6 is a plan view showing another example of the connection structure between each side wiring and the corresponding connection pad.
FIG. 7 is a schematic view showing an electro hydro dynamic (EHD) jet printing device performing one process when the display module is manufactured according to an embodiment of the present disclosure.
FIG. 8 is a schematic view showing a state where a liquid material is discharged from a nozzle of the EHD jet printing device.
FIG. 9 is a schematic view showing an example in which a straight-line masking pattern is formed on a glass substrate by the liquid material discharged while the nozzle of the EHD jet printing device is moved.
FIG. 10 is a schematic view showing an example in which the masking patterns are formed on the plurality of glass substrates by using the EHD jet printing device.
FIG. 11 is a flowchart showing a manufacturing process of a display module according to an embodiment of the present disclosure.
FIG. 12 is a process view showing a process of forming a side wiring in an edge area of a glass substrate during the manufacturing process of a display module according to an embodiment of the present disclosure.
FIG. 13 is a flowchart showing a manufacturing process of a display module according to another embodiment of the present disclosure.
FIG. 14 is a process view showing a process of positioning a side wiring in an edge area of a glass substrate during the manufacturing process of a display module according to another embodiment of the present disclosure.
FIG. 15 is a flowchart showing a manufacturing process of a display module according to another embodiment of the present disclosure.
FIG. 16 is a process view showing a process of positioning a side wiring in an edge area of a glass substrate during the manufacturing process of a display module according to another embodiment of the present disclosure.
FIG. 17 is a flowchart showing a manufacturing process of a display module according to another embodiment of the present disclosure.
FIG. 18 is a process view showing a process of positioning a side wiring in an edge area of a glass substrate during the manufacturing process of a display module according to another embodiment of the present disclosure.

### [BEST MODE]

Hereinafter, various embodiments will be described in more detail with reference to the accompanying drawings. Embodiments described in this specification may be variously modified. A specific embodiment may be illustrated in the drawings and described in detail in a detailed description. However, the specific embodiment shown in the accompanying drawings is provided only to allow various embodiments to be easily understood. Therefore, it should be understood that the spirit of the present disclosure is not limited by the specific embodiment shown in the accompanying drawings, and includes all the equivalents and substitutions included in the spirit and scope of the present disclosure.

Terms including ordinal numbers such as "first" and "second," may be used to describe various components. However, these components are not limited by these terms. The terms are used only to distinguish one component from another component.

It should be further understood that terms "include" and "comprise" used in this specification specify the presence of features, numerals, steps, operations, components, parts mentioned in this specification, or combinations thereof, and do not preclude the presence or addition of one or more other features, numerals, steps, operations, components, parts, or combinations thereof. It is to be understood that when one component is referred to as being "connected to" or "coupled to" another component, it may be directly connected to or directly coupled to another component, or may be connected to or coupled to another component, having a third component interposed therebetween. On the other hand, it is to be understood that when one component is referred to as being "directly connected to" or "directly coupled to" another component, it may be connected or coupled to another component without a third component interposed therebetween.

In the present disclosure, the expression "the same" may be used to indicate not only the completely same, but also the same including a difference taking into account a processing error range.

In describing the present disclosure, omitted is a detailed description of a case where it is decided that the detailed description for the known functions or configurations related to the present disclosure may unnecessarily obscure the gist of the present disclosure.

In the present disclosure, a display module may be a micro light emitting diode (micro LED or µ LED) display panel. The display module may be one of a flat-panel display panels and include a plurality of inorganic light emitting diodes (inorganic LEDs), each having a size of 100 micrometers or less. The micro LED display module may provide better contrast, response time and energy efficiency compared to a liquid crystal display (LCD) panel that require a backlight. Both an organic light emitting diode (organic LED) and the micro LED, which is an inorganic light emitting device, may have good energy efficiency. However, the micro LED may have higher brightness, higher luminous efficiency, and longer lifespan than the OLED. The micro LED may be a semiconductor chip which may emit light by itself when power is supplied thereto. The micro LED may have fast response speed, low power, and high luminance. In detail, the micro LED may have a higher efficiency of converting electricity into photons than a conventional liquid crystal display (LCD) or the organic light emitting diode (OLED). That is, the micro LED may have a higher "brightness per watt" compared to the conventional LCD or OLED display. Accordingly, the micro LED may produce the same brightness with about half the energy compared to the conventional LED (having width, length, and height each exceeding 100 µm) or the OLED. In addition, the micro LED may realize high resolution and excellent color, contrast and brightness, thus accurately express a wide range of colors, and implement a clear screen even in bright sunlight. In addition, the micro LED may be strong against a burn-in phenomenon and have low heat increase, and its long lifespan may thus be guaranteed without deformation.

In the present disclosure, the micro LED may have a flip chip structure in which anode and cathode electrodes are positioned on the same first surface and a light-emitting surface is positioned on a second surface opposite to the first surface on which the electrodes are positioned.

In the present disclosure, a glass substrate may have a front surface on which a thin film transistor (TFT) layer is positioned, a TFT circuit being positioned in the TFT layer, and have a rear surface on which a circuit is positioned, the circuit supplying power to the TFT circuit and being electrically connected to a separate control board. The TFT circuit may drive a plurality of pixels disposed on the TFT layer.

In the present disclosure, the front surface of the glass substrate may be divided into an active area and a dummy area. The active area may be an area occupied by the TFT layer on the front surface of the glass substrate, and the dummy area may be an area excluding the area occupied by the TFT layer on the front surface of the glass substrate.

In the present disclosure, an edge area of the glass substrate may be the outermost portion of the glass substrate. In addition, the edge area of the glass substrate may be an area other than the area where the circuit of the glass substrate is positioned. The edge area of the glass substrate may also include a side surface of the glass substrate, a portion of the front surface of the glass substrate that is adjacent to this side surface, and a portion of the rear surface of the glass substrate. The glass substrate may be a quadrangle type. In detail, the glass substrate may have a shape of a rectangle or a square. The edge area of the glass substrate may include at least one side of the four sides of the glass substrate.

In the present disclosure, a plurality of side wirings may be arranged at a predetermined distance from each other in the edge area of the glass substrate. The plurality of side wirings may each have one end that is electrically connected to a plurality of first connection pads positioned in the edge area included in the front surface of the glass substrate, and the other end that is electrically connected to a plurality of second connection pads positioned in the edge area included in the rear surface of the glass substrate. The plurality of first connection pads may each be connected to the TFT circuit disposed on the front surface of the glass substrate through wiring, and the plurality of second connection pads may be connected to a driver circuit disposed on the rear surface of the glass substrate through wiring.

In the present disclosure, the display module may be bezel-less by including the plurality of side wirings to minimize the dummy area and maximize the active area on the front surface of the TFT substrate, and the micro LEDs may thus be mounted more densely in the display module. The bezel-less display module may thus provide a large (lateral flow device LFD) display device which may maximize its active area when the plurality of display modules are connected to each other. In this case, each display module may minimize the dummy area to maintain the same pitch between pixels of display modules adjacent to each other as a pitch between the pixels in a single display module. It is thus possible to prevent a seam from appearing in a connection portion between the display modules.

In the present disclosure, an edge in the edge area included in the dummy area of the glass substrate may be chamfered to have a chamfered surface having a predetermined angle. The chamfered surface may be positioned at an edge between the front surface and the side surface of the glass substrate and at an edge between the rear surface and the side surface of the glass substrate. The side wiring may be formed by laser processing, and here, the chamfered surface may enable a laser beam irradiation section to be away from the front surface and the rear surface of the glass substrate by a predetermined distance to prevent damage to various devices or circuits mounted on the front surface and rear surface of the glass substrate by a laser beam.

The present disclosure describes that the plurality of side wirings are positioned only in two of the four sides of the glass substrate in the edge area provided on the glass substrate. However, the present disclosure is not limited hereto, and the plurality of side wirings may be positioned only in one of the four sides or in three or more thereof as needed.

In the present disclosure, the display module may include a glass substrate on which the plurality of LEDs are mounted and the side wirings are positioned. The display module may be applied and installed in an electronic product or electric field that requires a wearable device, a portable device, a handheld device, or any of various displays as a single unit, and applied to a display device such as a monitor for a personal computer (PC), a high-resolution television (TV), a signage (or digital signage) or an electronic display when the plurality of display modules are assembled and arranged in a matrix type.

Hereinafter, the display module according to an embodiment of the present disclosure is described with reference to the drawings.

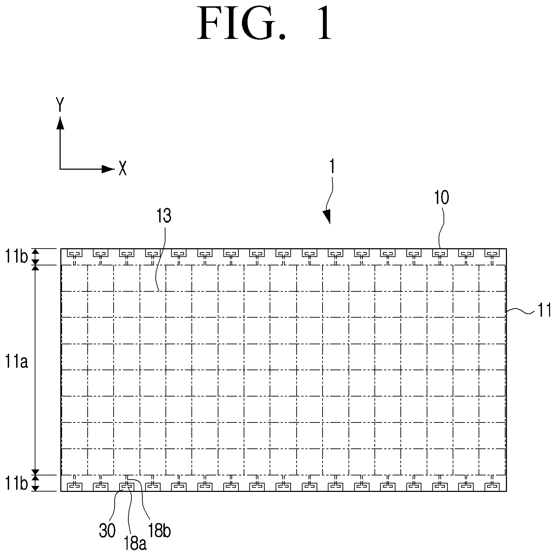

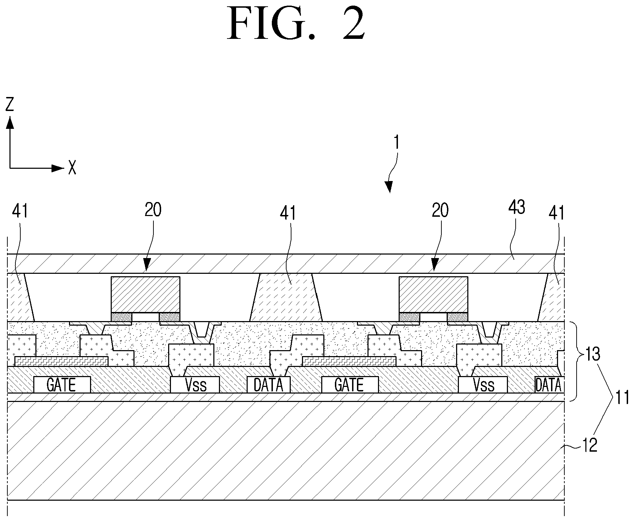

FIG. 1 is a plan view schematically showing a display module according to an embodiment of the present disclosure; and FIG. 2 is a cross-sectional view schematically showing the display module according to an embodiment of the present disclosure.

Referring to FIGS. 1 and 2, a display module 1 may include a TFT substrate 11 and a plurality of micro LEDs 20 arranged on the TFT substrate 11.

The TFT substrate 11 may include: a glass substrate 12; a TFT layer 13 positioned on a front surface of the glass substrate 12 and including a thin film transistor (TFT) circuit; and a plurality of side wirings 30 supplying power to the TFT circuit in the TFT layer 13 and a TFT circuit on a rear surface of the glass substrate 12, and electrically connected to a circuit (not shown) that is electrically connected to a separate control board.

The TFT substrate 11 may include an active area 11a where an image may be expressed on the front surface and a dummy area 11b where no image is expressed on the front surface.

The active area 11a may be divided into a plurality of pixel areas 13 where the plurality of pixels are respectively arranged. The plurality of pixel areas 13 may be partitioned in any of various shapes, for example, in a matrix shape. Each pixel area 13 may include a sub-pixel area where multi-color micro LEDs, which are a plurality of sub-pixels, are mounted, and a pixel circuit area where a pixel circuit for driving each sub-pixel is disposed.

The plurality of micro LEDs 20 may be transferred to the pixel circuit area of the TFT layer 11b, and electrode pads of each micro LED may be electrically connected to electrode pads positioned in the sub-pixel area of the TFT layer 11b, respectively. A common electrode pad may be positioned in a straight line in consideration of arrangement of three micro LEDs 20 arranged parallel to one another. The plurality of micro LEDs may be the sub-pixels included in a single pixel. In the present disclosure, the micro LED and the sub-pixel are used interchangeably.

A pixel driving method of the display module 1 according to an embodiment of the present disclosure may be an active matrix (AM) driving method or a passive matrix (PM) driving method. In the display module 1, a pattern of a wiring to which each micro LED is electrically connected may be formed by the AM driving method or the PM driving method.

The dummy area 11b may be included in an edge area of the glass substrate 12. For example, in the present disclosure, an edge area A is an area where the plurality of side wirings are positioned, and may include a first area corresponding to a side surface SS of the glass substrate, a second area corresponding to a portion of a front surface FS of the glass substrate, adjacent to the side surface SS of the glass substrate, and a third area corresponding to a portion of a rear surface RS of the glass substrate, adjacent to the side surface SS of the glass substrate.

A plurality of first connection pads 18a may be arranged at a predetermined distance from each other in the second area. Each of the plurality of first connection pads 18a may be electrically connected to each sub-pixel through wiring 18b.

A plurality of second connection pads 19a may be arranged at a predetermined distance from each other in the third area. Each of the plurality of second connection pads 19a may be electrically connected to the circuit disposed on the rear surface of each glass substrate through wiring 19b.

The plurality of side wirings 30 electrically connecting the plurality of first and second connection pads 18a and 19a to each other may be positioned in the edge area A of the glass substrate 12. In this case, the plurality of first and second connection pads 18a and 19a may be first disposed on the glass substrate 12 before the plurality of side wirings 30. For example, one first connection pad 18a and one second connection pad 19a may correspond to one side wiring 30. Accordingly, one end of one side wiring 30 may be electrically connected to one first connection pad 18a, and the other end of one side wiring 30 may be electrically connected to one second connection pad 19a.

The number of first and second connection pads 18a and 19a positioned in the dummy area 11b may depend on the number of pixels, and depend on a pixel driving method of the TFT circuit disposed in the active area 11a. For example, the active matrix (AM) driving method in which the TFT circuit disposed in the active area 11a drives each pixel individually may require more wirings and connection pads compared to the passive matrix (PM) driving method in which the TFT drives the plurality of pixels in a horizontal line and a vertical line.

Referring to FIG. 2, the display module 1 may be provided with a black matrix 41 partitioning the plurality of micro LEDs 20, and a transparent cover layer 43 protecting the plurality of micro LEDs 20 and the black matrix 41 together. In this case, a touch screen panel (not shown) may be stacked on one surface of the transparent cover layer 43.

The plurality of micro LEDs 20 may be inorganic light emitting devices made of an inorganic light emitting material. In addition, the plurality of micro LEDs 20 may be semiconductor chips which may emit light by themselves when power is supplied thereto. The plurality of micro LEDs 20 may each have a predetermined thickness, and may each be a square having the same width and length, or a rectangle having different widths and lengths. The micro LED may realize real high dynamic range (HDR), and provide higher luminance, more improved black expression, and a higher contrast ratio compared to an organic light emitting diode (OLED). A size of the micro LED may be 100 pm or less, or preferably 30 um or less. The plurality of micro LEDs 20 may each have a flip chip structure in which anode and cathode electrodes are positioned on the same surface and a light-emitting surface is positioned opposite to the electrodes.

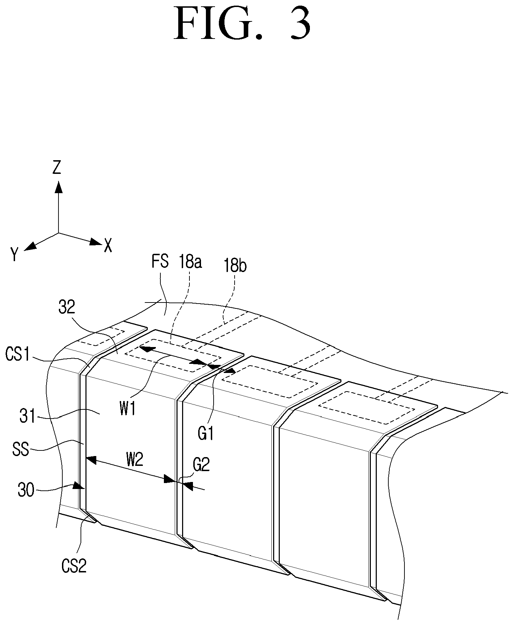

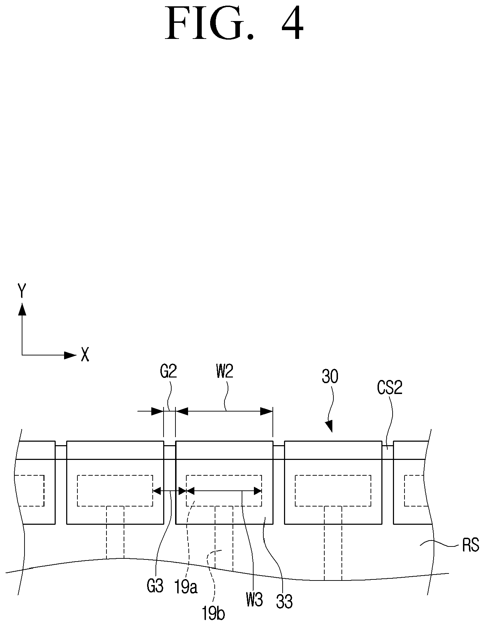

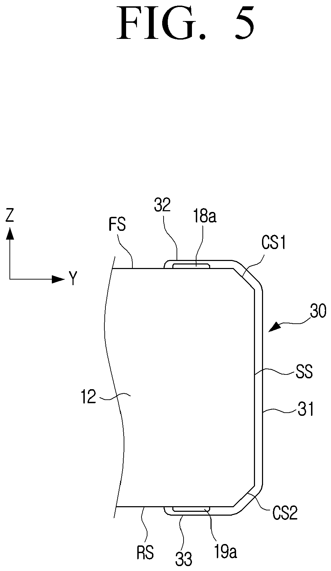

FIG. 3 is a partially enlarged view showing that the plurality of side wirings are arranged at a predetermined distance from each other in the display module according to an embodiment of the present disclosure; FIG. 4 is a bottom view showing an example of a connection structure between a side wiring and a corresponding connection pad; and FIG. 5 is a schematic side cross-sectional view showing the connection structure between the side wiring and the connection pad shown in FIG. 3.

Referring to FIG. 3, the side wiring 30 may be disconnected by being scratched or dented when the glass substrate 12 collides with a surrounding structure (e.g., equipment used in a process) while being processed or transported. To prevent this event, the glass substrate 12 may have a first chamfered surface CS1 and a second chamfered surface CS2, formed by grinding.

The first chamfered surface CS1 may be formed by chamfering an edge where the side surface SS and front surface FS of the glass substrate are in contact with each other. The second chamfered surface CS2 may be formed by chamfering an edge where the side surface SS and rear surface RS of the glass substrate are in contact with each other.

The plurality of first connection pads 18a may be arranged at a predetermined distance G1 from each other on the front surface FS of the glass substrate, corresponding to the second area of the edge area.

Some of the first connection pads 18a may be in electrical connection through the wiring 18b positioned in the TFT layer 13. In this case, the wiring 18b may be a gate signal wiring or a data signal wiring of the TFT layer 13.

Referring to FIG. 4, the plurality of second connection pad 19a may be arranged at a predetermined distance G3 from each other on the rear surface RS of the glass substrate. In this case, the distance G3 between the second connection pads 19a adjacent to each other may be approximately the same as the distance G1 between the first connection pads 18a adjacent to each other. Here, the same distance G3 between the adjacent second connection pads 19a may not only be completely the same distance, and but also be the distance taking into account a processing error range in processing the first and second connection pads 18a and 19a.

A width W1 of the first connection pad 18a may be approximately the same as a width W3 of the second connection pad 19a.

The second connection pad 19a may be electrically connected to the first connection pad 18a through the side wiring 30, and electrically connected to the circuit positioned on the rear surface RS of the glass substrate (e.g., circuit supplying power and connected to the control board) through the wiring 19b. In this case, the second connection pad 19a corresponding to one side wiring 30 may be disposed to correspond to the first connection pad 18a positioned on the front surface FS of the glass substrate corresponding to the same side wiring.

Referring to FIGS. 3 and 4, the side wirings 30 may each electrically connect the first connection pad 18a with the second connection pad 19a, and may be arranged at a predetermined distance from each other in the edge area A of the glass substrate.

The side wiring 30 may have a first portion 31 positioned on the side surface SS and first and second chamfered surfaces CS1 and CS2 of the glass substrate, a second portion 32 positioned on the front surface FS of the glass substrate, and a third portion 33 positioned on the rear surface RS of the glass substrate. The side wiring 30 may minimize a risk of disconnection as the edge of the glass substrate is processed into a surface by the first and second chamfered surfaces CS1 and CS2 described above.

The first to third portions 31, 32 and 33 of the side wiring 30 may be continuously connected and positioned in a substantially straight-line shape.

In this case, referring to FIG. 5, the second portion 32 of the side wiring may completely cover the first connection pad 18a for the connection pad to thus be in electrical connection and the third portion 33 of the side wiring may completely cover the second connection pad 19a for the connection pad to thus be in electrical connection. The first and second connection pads 18a and 19a may be covered by the side wiring as the connection pads are first positioned before the side wiring during a manufacturing process of the display module 1.

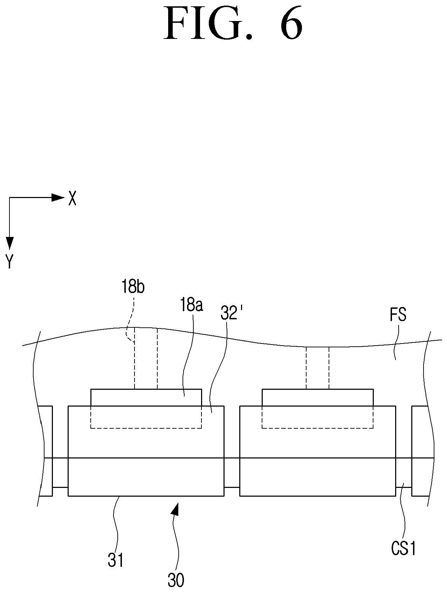

FIG. 6 is a plan view showing another example of the connection structure between each side wiring and the corresponding connection pad.

Referring to FIG. 6, a second portion 32' of the side wiring 30 may partially cover the first connection pad 18a rather than completely covering the first connection pad 18a based on a condition when the display module 1 is manufactured. Although not shown in the drawings, the third portion of the side wiring 30 may only cover the second connection pad 19a partially rather than completely covering the second connection pad 19a.

Alternatively, the connection structure may be implemented in such a manner that the second portion 32' of the side wiring 30 completely covers the first connection pad 18a, and the third portion of the side wiring 30 partially covers the second connection pad 19a. On the other hand, the connection structure may also be implemented in such a manner that the second portion 32' of the side wiring 30 partially covers the first connection pad 18a, and the third portion of the side wiring 30 completely covers the second connection pad 19a.

The side wiring 30 may preferably have the width W2 made as wide as possible to prevent the first portion 31 positioned on the side surface SS of the glass substrate from being disconnected by being scratched or dented by the surrounding structure when the glass substrate 12 is processed or transported, and to provide stable power supply and signal transmission to the TFT circuit through the side wiring 30. In this case, as shown in FIG. 3, the side wiring 30 may preferably maintain a minimum distance G2 in which the side wiring 30 may not be short-circuited from another side wiring adjacent thereto.

The distance G2 between the side wirings 30 adjacent to each other may be smaller than the distance G1 between the first connection pads 18a adjacent to each other, and smaller than the distance G3 between the second connection pads 19a adjacent to each other.

The side wirings 30 adjacent to each other may have the same distance G2 therebetween. Here, "the same" may be used to indicate not only the completely same, but also the same including a difference taking into account a processing error range in processing the side wiring.

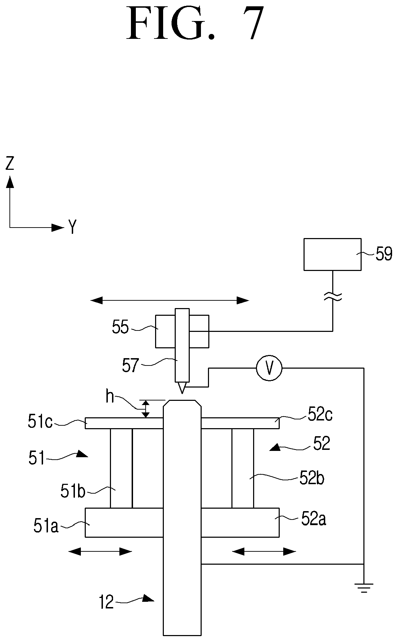

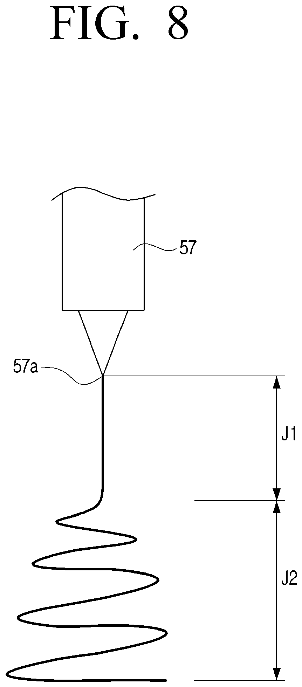

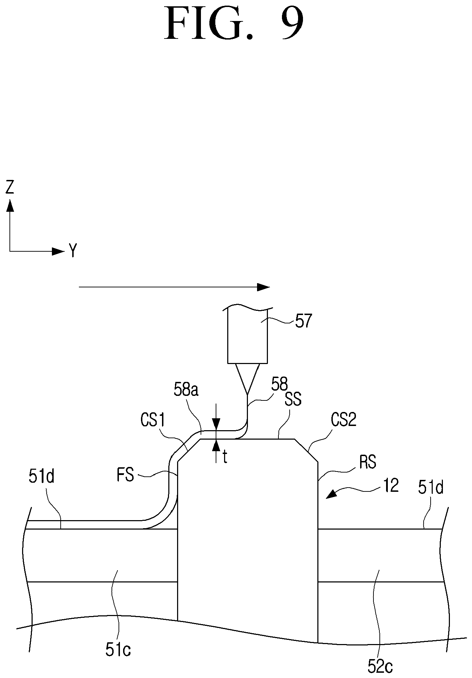

FIG. 7 is a schematic view showing an electro hydro dynamic (EHD) jet printing device performing one process when the display module is manufactured according to an embodiment of the present disclosure; FIG. 8 is a schematic view showing a state where a liquid material is discharged from a nozzle of the EHD jet printing device; and FIG. 9 is a schematic view showing an example in which a straight-line masking pattern is formed on a glass substrate by the liquid material discharged while the nozzle of the EHD jet printing device is moved.

In the present disclosure, the masking pattern may be used to ensure that the side wiring 30 has the width W2 made as wide as possible when the display module 1 is manufactured, the masking pattern providing a precise line width (e.g., 25 um) between the first side wirings 18a adjacent to each other and between the second connection pads 19a adjacent to each other.

Electro hydro dynamics (EHD) Jet printing jet printing may be used to have such a high-precision masking pattern.

EHD jet printing is technology for discharging a fine line width from the nozzle by action of pneumatic and electric field attraction. The EHD jet printing may implement a Taylor cone shape through a discharging port of the nozzle by the electric field attraction, and thus discharge the precise line width while maintaining a relatively wide distance between the nozzle and the glass substrate and the discharge of the fine line width compared to a general pneumatic dispenser. For example, the general pneumatic dispenser may require a separation distance between the nozzle and the glass substrate to be maintained very close to a level of 200 um or less to discharge a line width of about 400 um. However, the EHD jet printing may discharge a line width of about 50 um by maintaining a separation distance of about 1 mm.

In the present disclosure, FIG. 7 schematically shows an EHD jet printing device for forming the masking pattern in the edge area A of the glass substrate in a process of positioning the side wiring of the display module 1.

The EHD jet printing device may include first and second jigs 51 and 52 for supporting the glass substrate 12, a nozzle 57 for forming the masking pattern by discharging a liquid material having a predetermined viscosity to the edge area of the glass substrate 12, and a material storage container 59 for storing the liquid material.

The first and second jigs 51 and 52 may support the glass substrate 12 so that the edge area of the glass substrate 12 faces upward (e.g., toward the nozzle 57). In this case, the first jig 51 may support the front surface of the glass substrate, and the second jig 52 may support the rear surface of the glass substrate.

The first and second jigs 51 and 52 may be moved in left and right directions, that is, a horizontal direction, and clamp or release the glass substrate 12.

The first jig 51 may include a first base 51a, a first connection 51b, and a first upper plate 51c. The first base 51a may support a lower side of the front surface of the glass substrate 12, and the first upper plate 51c may support a portion of the glass substrate 12, adjacent to the edge area A.

For example, an upper surface of the first upper plate 51c may correspond to a portion of the glass substrate 12, adjacent to a boundary between the non-edge area (e.g., area where the TFT circuit of the glass substrate 12 is positioned) and edge area of the glass substrate 12. In this case, the upper surface of the first upper plate 51c may preferably be positioned slightly lower than the boundary. The reason is that the liquid material may not adhere to a corner between the upper surface of the first upper plate 51c and the front surface of the glass substrate 12 due to its own viscosity (see FIG. 9).

In this way, the glass substrate 12 may be clamped by the first and second jigs 51 and 52. Here, a height h from the upper surface of the first upper plate 51 to the side surface of the glass substrate 12 may be set in consideration of the portion of the glass substrate 12 described above, which is adjacent to the boundary between the area where the TFT circuit of the glass substrate 12 is positioned and the edge area of the glass substrate 12.

The second jig 52 may be disposed symmetrically to the first jig 51. The second jig 52 may include a second base 52a, a second connection 52b, and a second upper plate 52c. The second base 52a may support a lower side of the rear surface of the glass substrate 12, and the second upper plate 52c may support a portion of the glass substrate 12, adjacent to the edge area A.

In this case, the upper surface of the second upper plate 52c may preferably be positioned slightly lower than a boundary between the non-edge area of the rear surface of the glass substrate 12 and edge area of the glass substrate 12, similarly to positioning the upper surface of the first upper plate 51c as described above.

The nozzle 57 may be coupled to a movable holder 55. The movable holder 55 may be moved in a straight line reciprocally in the horizontal direction. The movable holder 55 may be driven by receiving a driving force by a forward/reverse rotation motor (not shown).

The nozzle 57 may be set to maintain a predetermined separation distance from the side surface of the glass substrate 12 so that the lowermost end of the nozzle does not interfere with the side surface of the glass substrate 12 while being moved in the straight line reciprocally in the horizontal direction.

The material storage container 59 may store the liquid material having a predetermined viscosity, and supply the material to the nozzle 57 at a predetermined rate. The liquid material may be, for example, ink that is heat-dried at 40°C or higher. In addition, the liquid material may have, for example, a viscosity of 3,000 to 100,000 cPs (preferably, 20,000 to 80,000 cPs). This viscosity of the liquid material may have a thixotropic index of 2.0 to 2.8. The thixotropic index represents a level of a material property in which the viscosity of the material is decreased as stress of the material is increased, whereas the viscosity is increased as the stress is decreased.

Referring to FIG. 8, the nozzle 57 having an EHD jet structure may have a straight jet flow section J1 and a spinning jet flow section J2 based on a separation distance between the glass substrate 12 and the nozzle 57 when the liquid material is discharged. Here, the straight jet flow may indicate that the liquid material flows along a straight line perpendicular to the nozzle 57, and the spinning jet flow may indicate that the liquid material flows in a spiral or cone shape when leaving the straight jet flow section and reaches the spinning jet flow section.

In the present disclosure, the masking pattern may be mainly formed by the spinning jet flow section J2. However, the masking pattern may also be formed by the straight jet flow section J1 when required to have a smaller line width.

Referring to FIG. 9, the glass substrate 12 may be vertically disposed on a support plate (not shown) when a masking pattern 58a is formed by the nozzle 57. Here, the glass substrate 12 may be clamped by the first and second jigs 51 and 52 in a state where the edge area of the glass substrate 12 faces the nozzle 57.

In this state, the nozzle 57 may be moved in a straight line in the horizontal direction while continuously discharging a liquid material 58 from above the first upper plate 51c through the glass substrate 12 to the upper surface of the second upper plate 52c.

The liquid material discharged from the nozzle 57 may form the masking pattern 58a on the upper surface of the first upper plate 51c, the edge area of the glass substrate 12, and the second upper plate 52c.

The first and second jigs 51c and 52c may then respectively be moved in the horizontal direction after forming the masking pattern 28 to be away from the glass substrate 12, thereby releasing the clamping of the glass substrate 12, and the masking pattern 58a may then remain only in the edge area of the glass substrate 12.

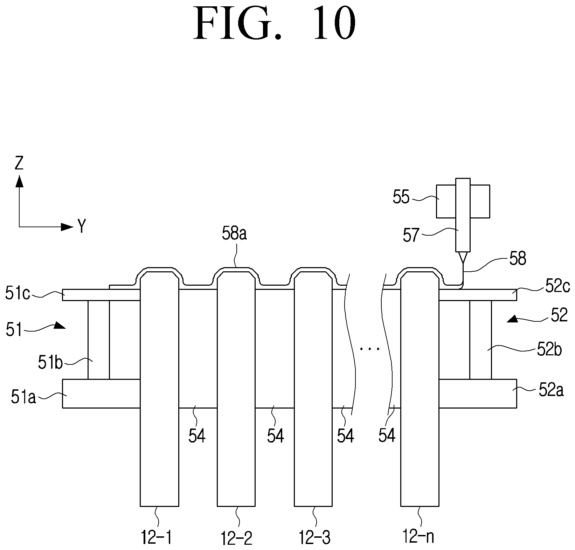

FIG. 10 is a schematic view showing an example in which the masking patterns are formed on the plurality of glass substrates by using the EHD jet printing device.

Referring to FIG. 10, at least two or more glass substrates 12-1, 12-2, 12-3, ..., and 12-n may be clamped between the first and second jigs 51 and 52. In this case, the plurality of glass substrates 12-1, 12-2, 12-3, ..., and 12-n may be arranged by respectively disposing spacers 54 between the adjacent glass substrates 12-1, 12-2, 12-3, ..., and 12-n.

In this case, the same masking pattern 58a may be formed in the edge areas of the respective glass substrates 12-1, 12-2, 12-3, ..., and 12-n by the nozzle continuously discharging the liquid material 58 while being horizontally moved from the first glass substrate 12-1 directly supported on the first jig 51 to the last glass substrate 12-n directly supported on the second jig 52.

Hereinafter, the description describes a method for manufacturing a display module 1 according to an embodiment of the present disclosure, in which the EHD jet printing device described above is used in a process of forming the side wiring.

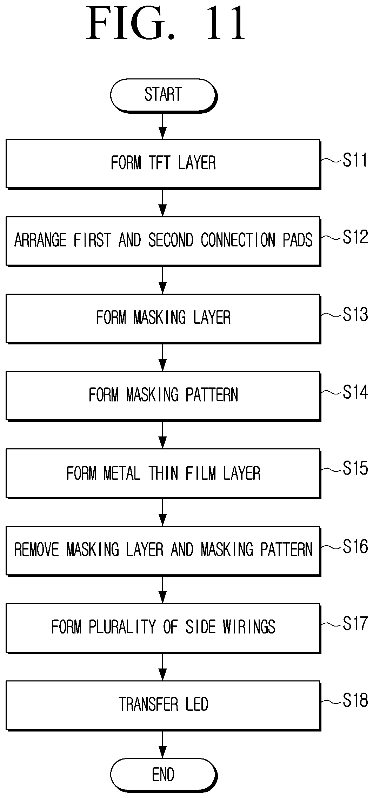

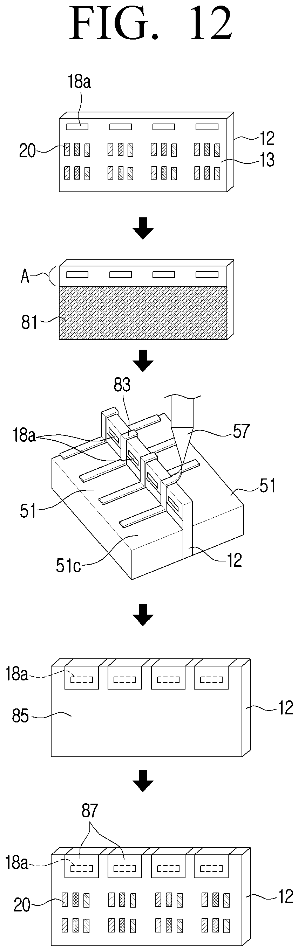

FIG. 11 is a flowchart showing a manufacturing process of a display module according to an embodiment of the present disclosure; and FIG. 12 is a process view showing a process of forming a side wiring in an edge area of a glass substrate during the manufacturing process of a display module according to an embodiment of the present disclosure.

Referring to FIG. 11, a thin film transistor (TFT) substrate 11 may be manufactured by forming a TFT layer 13 (see FIG. 2) on a glass substrate 12 (S11).

The TFT layer 13 may be any one of a low temperature poly silicon (LTPS) TFT, amorphous silicon (a-Si) TFT, and an oxide TFT. In this case, the TFT layer 13 may be formed integrally with one surface of the glass substrate 12.

Alternatively, the TFT layer 13 may be a thin film that is manufactured separately from the glass substrate 12 and then firmly attached to one surface of the glass substrate 12 through a coating process such as lamination.

Next, a plurality of first connection pads 18a may be arranged at a predetermined distance from each other in a second area included in an edge area of a front surface of the glass substrate, and a plurality of second connection pads 19a may be arranged at a predetermined distance from each other in a third area included in an edge area of a rear surface of the glass substrate (S12).

In this case, the edge area of the glass substrate in which a side wiring is to be positioned may be ground and planarized. The reason is that the side wiring formed in the edge area of the glass substrate may be positioned firmly without being peeled off from the glass substrate 12. To this end, the planarization may be performed in such a manner that first and second chamfered surface CS1 and CS2 are respectively formed by chamfering a corner that is a boundary between the side surface and front surface of the glass substrate 12, and a corner that is a boundary between the side surface and rear surface of the glass substrate, in the edge area of the glass substrate 12.

A plurality of side wirings 30 may then be formed on the edge area of the glass substrate 12. A process of forming the plurality of side wirings is sequentially described with reference to FIG. 11.

Referring to FIG. 12, a masking layer 81 of a large area, covering the front surface and rear surface of the glass substrate 12 may be formed (S13).

In this case, the masking layer 81 may be formed not to cover the edge area of the glass substrate, which is to form a metal thin film layer to be processed thereafter. The masking layer 81 may be formed by tape masking, screen printing, pad printing, or three-dimensional (3D) dispensing.

Next, the masking pattern 83 may be formed on the edge area of the glass substrate (S14).

The masking pattern 83 may have a continuous straight-line shape from between the first connection pads 18a adjacent to each other through the side surface of the glass substrate 12 to between the second connection pads 19a adjacent to each other by electro hydro dynamic (EHD) jet printing in a state where the glass substrate 12 is vertically clamped by the first and second jigs 51 and 52 described above.

In this case, the masking pattern 83 may be additionally stacked on the previously-discharged masking pattern when the nozzle 57 discharges a liquid material while being moved in a straight line reciprocally so that the masking pattern 83 has a greater thickness (e.g., thickness of 2.5 um or more) while having a fine line width (e.g., line width of 20 um or less), by using the EHD jet printing. Accordingly, a line width of the side wiring to be positioned thereafter may be formed wider as the line width of the masking pattern 83 is thinner. That is, the line width of the masking pattern may be inversely proportional to the line width of the side wiring.

Meanwhile, the EHD jet printing is based on technology of precisely discharging a liquid material, and the masking patterns 83 may not have completely the same line width, direction, shape, or the like due to liquid flow turbulence characteristics, non-uniformity of electric charging, vibration caused by a reciprocal motion of equipment stage, etc. However, this irregular characteristic may fall within an error range in a manufacturing process and do not lower a performance of the side wiring.

Next, a metal thin film layer 85 may be formed on the front surface, side surface and rear surface of the glass substrate 12 (S15) .

The metal thin film layer 85 may cover each of the first connection pads 18a and the second connection pads 19a corresponding to each of the first connection pads 18a.

The metal thin film layer 85 may be formed by loading the glass substrate 12 into a predetermined chamber (not shown) and then using a metal deposition method by sputtering.

Next, the masking layer 81 and the masking pattern 83 may be removed from the glass substrate 12 by using a stripping liquor (S16).

In this way, the metal thin film layer 85 formed on the masking layer 81 and the masking pattern 83 may also be removed while the masking layer 81 and the masking pattern 83 are removed from the glass substrate 12.

Accordingly, the metal thin film layer remaining in the edge area of the glass substrate 12 may be a plurality of side wirings 87 that electrically connect the first and second connection pads 18a and 19a to each other (S17).

The plurality of side wirings 87 may be arranged at a predetermined distance from each other in the edge area of the glass substrate. In this case, a distance G2 between the side wirings 30 adjacent to each other may be smaller than a distance G1 between the first connection pads 18a adjacent to each other, and smaller than a distance G3 between the second connection pads 19a adjacent to each other. The side wiring 30 may thus have a line width W2 made as wide as possible (see FIGS. 3 and 4).

The plurality of side wirings 87 may be formed on the edge area of the glass substrate 12, and a plurality of micro light emitting diodes (micro LEDs) arranged on a transfer substrate (not shown) may then be transferred to the TFT layer 13 (see FIG. 2) (S18).

The display module according to the present disclosure may have the side wiring made through any of various manufacturing methods described below in addition to the above-described manufacturing method. In describing the methods for manufacturing a display module described below, the description briefly describes a portion overlapping the above-described manufacturing method and describes a different process of forming the side wiring in detail.

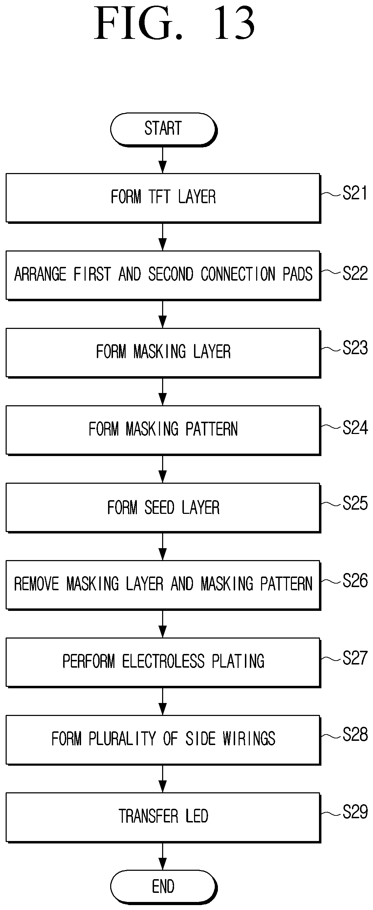

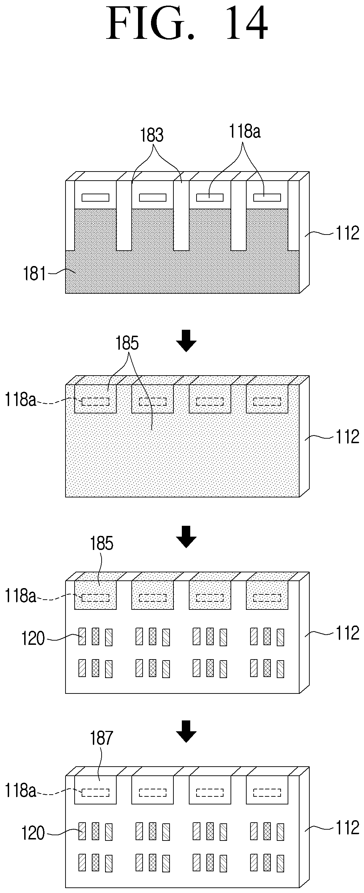

FIG. 13 is a flowchart showing a manufacturing process of a display module according to another embodiment of the present disclosure; and FIG. 14 is a process view showing a process of forming a side wiring in an edge area of a glass substrate during the manufacturing process of a display module according to another embodiment of the present disclosure.

Referring to FIG. 13, a thin film transistor (TFT) substrate may be manufactured by forming a TFT layer on the glass substrate (S21) .

Next, a plurality of first connection pads 118a may be arranged at a predetermined distance from each other in a second area included in an edge area of a front surface of the glass substrate 112, and a plurality of second connection pads (not shown) may be arranged at a predetermined distance from each other in a third area included in an edge area of a rear surface of the glass substrate 112 (S22).

Referring to FIG. 14, a masking layer 181 of a large area, covering the front surface and rear surface of the glass substrate 112 may be formed (S23).

Next, a masking pattern 183 may be formed on the edge area of the glass substrate 112 (S24).

The masking pattern 183 may have a continuous straight-line shape from between the first connection pads 118a adjacent to each other through the side surface of the glass substrate 112 to between the second connection pads adjacent to each other by electro hydro dynamic (EHD) jet printing in a state where the glass substrate 12 is vertically clamped by the first and second jigs 51 and 52 described above.

Next, a seed layer 185 may be formed on the front surface, side surface and rear surface of the glass substrate 112 (S25).

The seed layer 185 may cover each of the first connection pads 18a and the second connection pad 19a corresponding to each of the first connection pads 18a. The seed layer may be made of a conductor to which a liquid conductor made in an electroless manner, which is to be carried out below, may effectively adhere.

The seed layer 185 may form a side wiring together with the liquid conductor adhered to the seed layer 185 in the electroless manner. Accordingly, the side wiring may have a structure in which the seed layer 185 and the liquid conductor attached to a surface of the seed layer 185 are stacked.

Next, the masking layer 181 and the masking pattern 183 may be removed from the glass substrate 112 by using a stripping liquor (S26).

Here, the seed layer 185 formed on the masking layer 181 and the masking pattern 183 may also be removed while the masking layer 181 and the masking pattern 183 are removed from the glass substrate 112. Accordingly, the seed layer remaining in the edge area of the glass substrate 112 may cover and the first connection pad 118a and the second connection pad to electrically connect the connection pads to each other.

The glass substrate 112 may be put in a container (not shown) containing the liquid conductor for electroless plating and electroless plating may be performed (S27).

Accordingly, the liquid conductor may adhere to a surface of the seed layer 185 remaining in the edge area of the glass substrate 112, while having a predetermined thickness, thereby forming a side wiring 187 (S28).

The plurality of side wirings 187 may be arranged at a predetermined distance from each other in the edge area of the glass substrate, and thus have a line width made as wide as possible.

The plurality of side wirings 187 may be formed on the edge area of the glass substrate 112, and a plurality of micro light emitting diodes (micro LEDs) arranged on a transfer substrate (not shown) may then be transferred to the TFT layer (S29) .

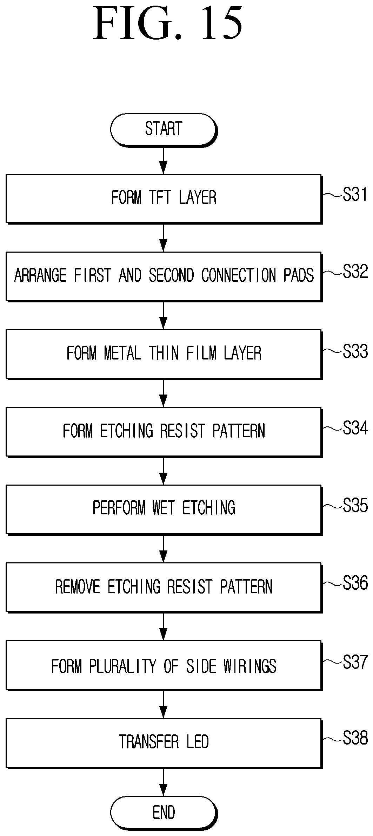

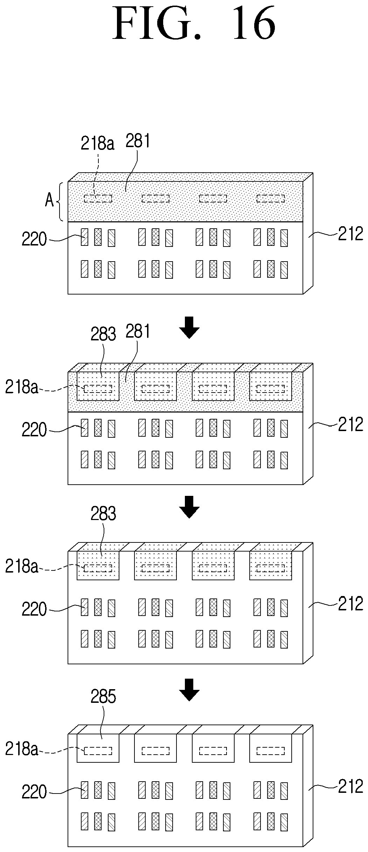

FIG. 15 is a flowchart showing a manufacturing process of a display module according to another embodiment of the present disclosure; and FIG. 16 is a process view showing a process of forming a side wiring in an edge area of a glass substrate during the manufacturing process of a display module according to another embodiment of the present disclosure.

Referring to FIG. 15, a thin film transistor (TFT) substrate may be manufactured by forming a TFT layer on a glass substrate 212 (S31).

Next, a plurality of first connection pads 218a may be arranged at a predetermined distance from each other in a second area included in an edge area of a front surface of the glass substrate 212, and a plurality of second connection pads 19a (not shown) may be arranged at a predetermined distance from each other in a third area included in an edge area of a rear surface of the glass substrate 212 (S32).

Referring to FIG. 16, a metal thin film layer 281 may be formed on an edge area of the glass substrate 212 (S33).

In this case, the metal thin film layer 281 may cover a plurality of the first connection pads 218a and a plurality of the second connection pads.

An etching resist pattern 283 may be formed on the metal thin film layer 281 by EHD jet printing in correspondence to an area to be used for the side wiring connecting the first connection pad 218a and the second connection pad to each other (S34).

A portion of the metal thin film layer 281, not covered by the etching resist pattern 283, may be removed by wet etching (S35).

The etching resist pattern 283 covering a plurality of side wirings 285 may be removed (S36), and a remaining part of the metal thin film layer 281, not removed from the glass substrate 212 and electrically connecting the first connection pad 218a and the second connection pad to each other, may be formed as the side wiring 285 (S37).

The plurality of side wirings 285 may be arranged at a predetermined distance from each other in the edge area of the glass substrate, and thus have a line width made as wide as possible.

The plurality of side wirings 285 may be formed on the edge area of the glass substrate 212, and a plurality of micro light emitting diodes (micro LEDs) arranged on a transfer substrate (not shown) may then be transferred to the TFT layer (S38) .

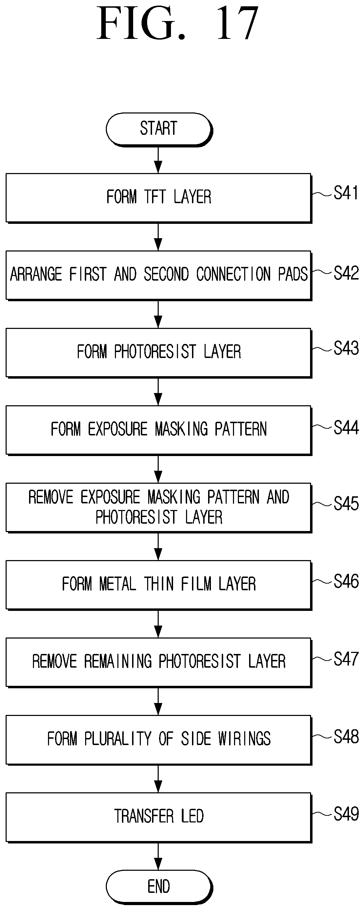

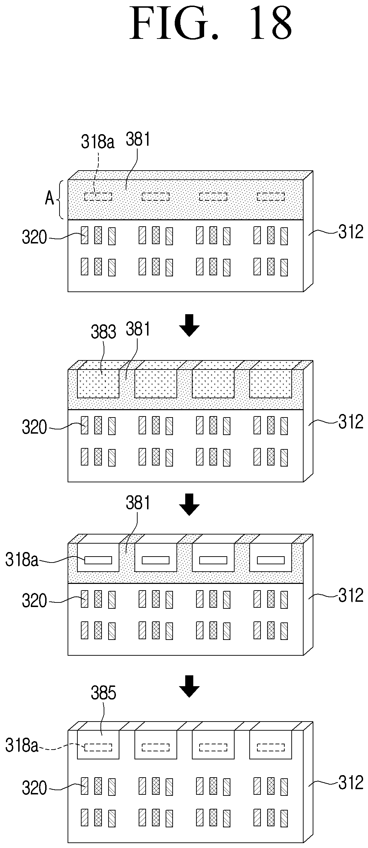

FIG. 17 is a flowchart showing a manufacturing process of a display module according to another embodiment of the present disclosure; and FIG. 18 is a process view showing a process of forming a side wiring in an edge area of a glass substrate during the manufacturing process of a display module according to another embodiment of the present disclosure.

Referring to FIG. 17, a thin film transistor (TFT) substrate may be manufactured by forming a TFT layer on the glass substrate 312 (S41).

Next, a plurality of first connection pads 318a may be arranged at a predetermined distance from each other in a second area included in an edge area of a front surface of the glass substrate 312, and a plurality of second connection pads (not shown) may be arranged at a predetermined distance from each other in a third area included in an edge area of a rear surface of the glass substrate 312 (S42).

Referring to FIG. 18, a photoresist layer 381 may be formed on an edge area of the glass substrate 312 (S43).

An exposure masking pattern 283 may be formed on the photoresist layer 381 by EHD jet printing in correspondence to each area to be used for the side wiring for connecting the first connection pad 218a and the second connection pad to each other (S44)

The exposure masking pattern 383 and a portion of the photoresist layer 381 covered by the exposure masking pattern 383 may be removed through exposure and development (S45).

Accordingly, the remaining photoresist layer 381 may remain in the edge area of the glass substrate 312, and the first connection pattern 318a and the second connection pattern may be exposed through a portion of the glass substrate 312, from which the photoresist layer 381 is removed.

A metal thin film layer 385 may be deposited in the edge area of the glass substrate 312, where the first connection pattern 318a and the second connection pattern are exposed (S46) . In this case, a portion of the metal thin film layer 385 may be formed on the remaining photoresist layer 381.

The remaining photoresist layer 381 may be removed from the glass substrate 312 by using a cleaning solution (S47).

In this way, the remaining photoresist layer 381 may be removed from the glass substrate 312, and the metal thin film layer 385 remaining on the glass substrate 312 may then be a side wiring 385 electrically connecting the first connection pad 318a and the second connection pad to each other (S48). Here, the same reference number 385 is used for the metal thin film layer and the side wiring.

The plurality of side wirings 385 may be arranged at a predetermined distance from each other in the edge area of the glass substrate, and thus have a line width made as wide as possible.

The plurality of side wirings 385 may be formed on the edge area of the glass substrate 312, and a plurality of micro light emitting diodes (micro LEDs) arranged on a transfer substrate (not shown) may then be transferred to the TFT layer (S49) .

The display module according to the present disclosure may have the side wiring having a wide line width as the masking pattern of fine line width may be formed through the characteristics of the EHD jet printing, secure high processing capability without any complicated maintenance procedure, and respond quickly and flexibly to a change in the materials and masking patterns.

Although the various embodiments of the present disclosure have been individually described hereinabove, each embodiment is not necessarily implemented alone, and may also be implemented so that the configurations and operations thereof are combined with those of one or more other embodiments.

In addition, although the embodiments are shown and described in the present disclosure as above, the present disclosure is not limited to the above-mentioned specific embodiments, and may be variously modified by those skilled in the art to which the present disclosure pertains without departing from the gist of the present disclosure as disclosed in the accompanying claims. These modifications should also be understood to fall within the scope and spirit of the present disclosure.

### [INDUSTRIAL APPLICABILITY]

The present disclosure relates to a display module and a method for manufacturing the same.

## Claims

1. A display module comprising:
a thin film transistor (TFT) substrate comprising:
a glass substrate, and
a TFT layer provided on a front surface of the glass substrate, the TFT layer comprising a TFT circuit;
a plurality of light emitting diodes provided on the TFT layer;
a plurality of first connection pads provided at a distance from each other on the front surface of the glass substrate and electrically connected to the TFT circuit;
a plurality of second connection pads provided at a distance from each other on a rear surface of the glass substrate and electrically connected to a circuit for supplying power and connected to a control board; and
a plurality of side wirings electrically connecting each of the plurality of first connection pads to respective connection pads of the plurality of second connection pads,
wherein each side wiring of the plurality of side wirings has a width greater than widths of a respectively connected first connection pad and second connection pad.

2. The display module as claimed in 1, wherein a distance between adjacent side wirings is less than a distance between adjacent connection pads of the plurality of first connection pads or is less than a distance between adjacent connection pads of the plurality of second connection pads.

3. The display module as claimed in 1, wherein each side wiring of the plurality of side wirings comprises a first end covering at least a portion of one first connection pad and a second end covering at least a portion of one second connection pad.

4. A method for manufacturing a display module, the method comprising:
forming a thin film transistor (TFT) layer on a front surface of a glass substrate;
arranging a plurality of first connection pads on a portion of the front surface of the glass substrate adjacent to a side surface of the glass substrate,
arranging a plurality of second connection pads on a portion of a rear surface of the glass substrate adjacent to the side surface of the glass substrate;
forming a plurality of side wirings respectively connecting the plurality of first connection pads to the plurality of second connection pads; and
transferring a plurality of light emitting diodes to the TFT layer,
wherein each side wiring of the plurality of side wirings has a width greater than widths of a respectively connected first connection pad and second connection pad.

5. The method as claimed in 4, wherein the forming of the plurality of side wirings comprises:
forming a masking layer such that the masking layer covers the front surface and the rear surface of the glass substrate and exposes the plurality of first connection pads and the plurality of second connection pads;
forming a masking pattern from between adjacent connection pads of the plurality of first connection pads through the side surface of the glass substrate to between adjacent connection pads of the plurality of second connection pads;
forming a metal thin film layer connecting each of the plurality of first connection pads to respective connection pads of the plurality of second connection pads; and
removing the masking pattern and the masking layer from the glass substrate.

6. The method as claimed in 5, wherein the masking pattern is formed by electrohydrodynamic (EHD) jet printing, and
wherein the forming of the masking pattern comprises:
clamping the glass substrate by a jig such that the side surface of the glass substrate faces upward; and
continuously forming the masking pattern on the front surface, the side surface and the rear surface of the glass substrate by discharging a material for the masking pattern while a nozzle from which the material for the masking pattern is discharged is moved in a straight line and in a horizontal direction.

7. The method as claimed in 6, wherein the masking pattern comprises a plurality of straight lines parallel to each other, and
wherein each straight line of the plurality of straight lines has a width less than a distance between adjacent connection pads of the plurality of first connection pads and less than a distance between adjacent connection pads of the plurality of second connection pads.

8. The method as claimed in 6, wherein in the clamping of the glass substrate by the jig, the glass substrate is disposed in a direction perpendicular to a movement direction of the nozzle.

9. The method as claimed in 6, wherein the forming of the masking pattern further comprises increasing a thickness of each straight line of the plurality of straight lines by stacking material used for the masking pattern on the masking pattern while the nozzle is reciprocally moved.

10. The method as claimed in 6, wherein in the forming of the masking pattern, two or more glass substrates are clamped by the jig, and the glass substrates adjacent to each other are disposed at a distance from each other by a spacer.

11. The method as claimed in 10, wherein the masking pattern is formed on edge areas of the two or more glass substrates by the nozzle discharging a liquid material while being moved above the two or more glass substrates.

12. The method as claimed in 5, wherein the metal thin film layer is formed by a deposition process.

13. The method as claimed in 4, wherein the forming of the plurality of side wirings comprises:
forming a masking layer such that the masking layer covers the front surface and the rear surface of the glass substrate and exposes the plurality of first connection pads and the plurality of second connection pads;
forming a straight-line masking pattern from between adjacent connection pads of the plurality of first connection pads through the side surface of the glass substrate to between adjacent connection pads of the plurality of second connection pads;
forming a seed layer connecting each of the plurality of first connection pads to respective second connection pads;
removing the masking pattern and the masking layer from the glass substrate; and
stacking a metal thin film layer on the seed layer by electroless plating.

14. The method as claimed in 4, wherein the forming of the plurality of side wirings comprises:
depositing a metal thin film layer covering portions of the side surface of the glass substrate and portions of the front surface and the rear surface of the glass substrate on which the plurality of first connection pads and the plurality of second connection pads are respectively arranged;
forming an etching resist pattern on the metal thin film layer by electrohydrodynamic (EHD) jet printing to cover an area to be used for the plurality of side wirings;
removing a portion of the metal thin film layer not covered by the etching resist pattern by wet etching; and
removing the etching resist pattern.

15. The method as claimed in 4, wherein the forming of the plurality of side wirings comprises:
forming a photoresist layer covering portions of the side surface of the glass substrate and portions of the front surface and the rear surface of the glass substrate on which the plurality of first connection pads and the plurality of second connection pads are respectively arranged;
forming an exposure masking pattern on the photoresist layer by electrohydrodynamic (EHD) jet printing to cover an area to be used for the plurality of side wirings;
removing the exposure masking pattern and the photoresist layer covered by the exposure masking pattern by exposure and development;
depositing a metal thin film layer connecting each of the plurality of first connection pads to respective second connection pads of the plurality of second connection pads; and
removing the photoresist layer.
